# EUROPÄISCHE PATENTSCHRIFT

(11) **EP 1 262 575 B1**
(45) Veröffentlichungstag und Bekanntmachung des Hinweises auf die Patenterteilung: **27.10.2004**
(21) Anmeldenummer: 02007695.6
(22) Anmeldetag: 12.04.2002
(51) Int. Cl.: C23C 16/02, C23C 14/02, C23C 16/458, C23C 14/50, C23C 14/54, C23C 16/46

(54) **Verfahren und Vorrichtung zur Aufheizung von Substraten**
Method and apparatus for heating of substrates
Procédé et appareil pour le chauffage des substrats

(30) Priorität: 25.05.2001 DE 10125675
(43) Veröffentlichungstag der Anmeldung: 04.12.2002
(73) Patentinhaber: Schott Glas, 55122 Mainz (DE)
(72) Erfinder: Eggert, Hartmut, 55270 Ober-Olm (DE); Kunkel, Armin, 55452 Rümmelsheim (DE); Vogt, Jürgen, 55413 Oberheimbach (DE); Meyer, Rolf, 37581 Bad Gandersheim (DE); Wörner, Peter, 55116 Mainz (DE)
(74) Vertreter: Blumbach, Kramer & Partner GbR

(56) Entgegenhaltungen:
- EP-A- 0 339 279
- US-A- 4 710 428
- US-A- 5 951 774
- PATENT ABSTRACTS OF JAPAN vol. 018, no. 377 (C-1225), 15. Juli 1994 (1994-07-15) & JP 06 101050 A (TOSHIBA MACH CO LTD), 12. April 1994 (1994-04-12)
- PATENT ABSTRACTS OF JAPAN vol. 006, no. 055 (E-101), 10. April 1982 (1982-04-10) & JP 56 167332 A (FUJITSU LTD), 23. Dezember 1981 (1981-12-23)

## Beschreibung

Die vorliegende Erfindung betrifft ein Verfahren zur Aufheizung und Beschichtung von Glassubstraten. Weiter betrifft die Erfindung eine externe Vorheizung.
Beim herkömmlichen Verfahren zum Aufheizen insbesondere von Glasteilen erfolgt die Aufheizung in einem Prozess. Dieses Verfahren ist energie- und zeitaufwendig.

US 4710428 zeigt die Beschichtung eines Wafers in einer CVD-Kammer. Die Wafer werden in der CVD-Anlage über ein Förderband transportiert, aufgeheizt und beschichtet. JP 06101050 offenbart einen CUD-Prozess zur Beschichtung von Glassubstraten.
Die US 5 351 774 gibt unter anderen einen Träger zur Aufnahme von Wafern an.
Die Aufgabe der vorliegenden Erfindung liegt darin, ein wirtschaftliches und umweltfreundliches Verfahren zur externen Aufheizung von Glassubstraten bereitzustellen.
Die Aufgabe wird durch ein Verfahren gemäß Anspruch 1.

Der Prozess ist energiesparend. Durch die Aufheizung ist der Verschleiß an der Beschichtungsvorrichtung verringert. Die Aufheizung ist homogener.

Die Qualität der Beschichtung ist verbessert. Die notwendige Temperaturanpassung kann ohne Beeinflussung auf die Prozesszeit umgesetzt werden. Das Verfahren ermöglicht eine stabile Prozessführung.

Eine bevorzugte Ausgestaltung der Erfindung besteht darin, dass die Aussparungen in der Glaskeramikplatte eine Substrataufnahme aufweisen. Die Glaskeramikplatte ist aufgrund der schwachen Wärmeleitung für das Verfahren besonders geeignet.

Eine bevorzugte Ausgestaltung der Erfindung vewendet eine Glaskeramikplatte, die mindestens zwei aufeinander gelegte Platten enthält, wobei die zwei Platten unterschiedliche Öffnungen aufweisen. Werden die Glaskeramikplatten mit den unterschiedlich grosse Öffnungen aufeinander gelegt, so bildet sich die Substrataufnahme. Durch zwei Platten werden die Wärmeverluste zusätzlich verringert. Die Herstellung der Substrataufnahmen wird erleichtert.

Eine bevorzugte Ausgestaltung der Erfindung sieht die Prozessführung bei einer Temperatur von 500 °C bis 800 °C vor. In diesem Temperaturbereich werden gute Ergebnisse erzielt.

Bevorzugt ist vorgesehen, dass die Substrate mit mindestens einer Schicht beschichtet werden.

Bevorzugt ist die Beschichtung der Substrate mit mindestens einem der nachfolgenden Verfahren umfasst vorgesehen: CVD (Chemical-Vapor-Deposition), PVD (Physical-Vapor-Deposition), PECVD (Plasma-Enhanced-Chemical-Vapor-Deposition), PICVD (Plasma-Impulse-Chemical-Vapor-Deposition), LPCVD (Low-Pressure-Chemical-Vapor-Deposition) oder TCVD (Thermical-Chemical-Vapor-Deposition).

Bevorzugt wird eine Vorrichtung zur Aufheizung von Substrate verwendet, bei welcher die Heizvorrichtung mit einer Glaskeramikplatte abgedeckt ist und die für das Substrat eine passende Aussparung aufweist.

Bevorzugt ist die Verwendung eines Infrarot-Hochtemperaturstrahlers. Diese Hochtemperaturstrahler haben eine höhere Lebensdauer.

Die Erfindung wird nachstehend anhand einer Zeichnung und von Beispielen näher erklärt.

### Zeichnung

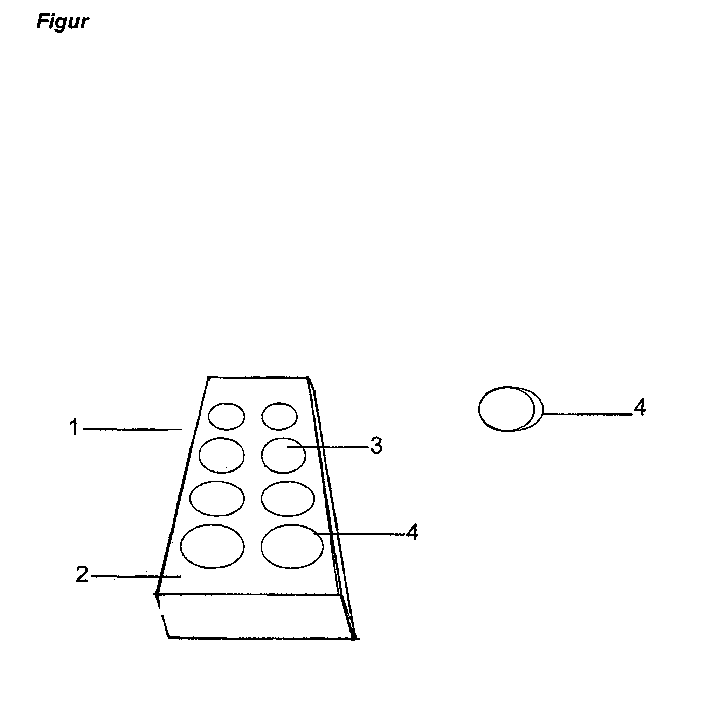

Die Zeichnung besteht aus der Figur.

Die Figur zeigt eine Vorrichtung zum Aufheizen von Substraten.

### Beispiel

Die Vorrichtung zur Aufheizung von Glassubstraten bestehend aus einer Heizvorrichtung zwei Glaskeramikplatten und Infrarot-Hochtemperaturstrahler wurde bei einer Temperatur von 500 °C betrieben. Durch die vorgeschaltete Aufheizung wurden 5300 Stück pro Stunde beschichtet.

### Vergleichsbeispiel

Im herkömmlichen Verfahren, wobei das Substrat in der Beschichtungsanlage aufgeheizt wurde konnten 3200 Stück pro Stunde beschichtet werden.

Ein Vergleich zwischen Beispiel und Vergleichsbeispiel zeigt, dass nach dem Verfahren gemäß der Erfindung die Ausbeute an beschichteten Substraten um 65 % gestiegen ist. Der Energieverbrauch für die Aufheizung lag um 50 % niedriger.

### Zeichnung

Die Figur zeigt eine Aufheizvorrichtung für Substrate. Die Vorrichtung (1) zur Aufheizung von Substraten weist eine Glaskeramikplatte (2) auf, mit der die Heizvorrichtung (3) abgedeckt ist. Die Glaskeramikplatte (2) weist für die Aufnahme von Substraten passende Aussparungen (4) auf. Die Aussparungen (4) entsprechen einer Substrataufnahme. Die Glaskeramikplatte (2) besteht aus mindestens zwei lose aufeinander gelegten Platten, die zwei unterschiedliche Öffnungen (4) aufweisen. Die im Innenbereich der Heizvorrichtung (3) angebrachte Heizstrahler sind Infrarot-Hochtemperaturstrahler.

## Patentansprüche

1. Verfahren zur Aufheizung und Beschichtung von Substraten, wobei
a) das zu beschichtende Glassubstrat mit der zu beschichtenden Fläche auf eine externe Heizvorrichtung, die mit einer Glaskeramikplatte abgedeckt ist und für das Substrat eine passende Aussparung aufweist, gesetzt wird,
b) das Substrat von unten auf die Prozesstemperatur für die Beschichtung aufgeheizt wird und
c) das Substrat aus der Heizvorrichtung entnommen wird und in eine Beschichtungskammer eingebracht und beschichtet wird.

2. Verfahren nach Anspruch 1, wobei die Aussparungen in der Glaskeramikplatte eine Substrataufnahme aufweisen.

3. Verfahren nach Anspruch 1 oder 2, wobei die Glaskeramikplatten mindestens zwei lose aufeinander gelegte Platten enthält, wobei die zwei Platten unterschiedliche Öffnungen aufweisen.

4. Verfahren nach mindestens einem der Ansprüche 1 bis 3, wobei die Temperatur im Innenbereich der Heizvorrichtung von 500 C bis 800 C beträgt.

5. Verfahren nach mindestens einem der Ansprüche 1 bis 4, wobei die Substrate mit mindestens einer Schicht beschichtet werden.

6. Verfahren nach mindestens einem der Ansprüche 1 bis 5, wobei die Beschichtung mindestens eines der nachfolgenden Verfahren umfasst: CVD (Chemical-Vapor-Deposition), PVD (Physical-Vapor-Deposition), PECVD (Plasma-Enhanced-Chemical Vapor-Deposition), PICVD (Plasma-Impulse-Chemical-Vapor-Deposition), LPCVD (Low-Pressure-Chamical-Vapor-Deposition) oder TCVD (Thermical-Chemical-Vapor-Deposition).

## Claims

1. A method of heating and coating substrates, wherein
a) the glass substrate for coating is laid with its surface for coating on an external heater which is covered by a glass ceramic plate and has a recess fitting the substrate,
b) the substrate is heated from below to the temperature for the coating process and
c) the substrate is taken out of the heater and inserted into and coated in a coating chamber.

2. A method according to claim 1, wherein the recesses in the glass ceramic plate comprise a substrate holder.

3. A method according to claim 1 or 2, wherein the glass ceramic plates contain at least two plates laid loosely on one another, wherein the two plates have different openings.

4. A method according to at least one of claims 1 to 3, wherein the temperature is in the inner region of the heater is 500 to 800°C.

5. A method according to at least one of claims 1 to 4, wherein the substrates are coated with at least one layer.

6. A method according to at least one of claims 1 to 5, wherein the coating process comprises at least one of the following methods: CVD (chemical vapour deposition), PVD (physical vapour deposition), PECVD (plasma-enhanced chemical vapour deposition), PICVD (plasma-impulse chemical vapour deposition), LPCVD (low-pressure chemical vapour deposition) or TCVD (thermal chemical vapour deposition).

## Revendications

1. Procédé de chauffage et de revêtement de substrats, dans lequel :
a) le substrat en verre à revêtir est placé, par sa surface à revêtir, sur un dispositif de chauffage externe, qui est recouvert d'une plaque de vitrocéramique et qui présente un évidement adapté au substrat ;
b) le substrat est chauffé par dessous jusqu'à la température de traitement pour le revêtement ; et
c) le substrat est retiré du dispositif de chauffage et introduit dans une enceinte de revêtement, dans laquelle il est revêtu.

2. Procédé selon la revendication 1, dans lequel les évidements, ménagés dans la plaque de vitrocéramique, présentent un logement de réception de substrat.

3. Procédé selon la revendication 1 ou 2, dans lequel les plaques de vitrocéramique comportent au moins deux plaques librement posées l'une sur l'autre, les deux plaques présentant des ouvertures différentes.

4. Procédé selon au moins l'une des revendications 1 à 3, dans lequel la température est comprise dans une plage de 500°C à 800°C, dans la zone intérieure du dispositif de chauffage.

5. Procédé selon au moins l'une des revendications 1 à 4, dans lequel les substrats sont revêtus d'au moins une couche.

6. Procédé selon au moins l'une des revendications 1 à 5, dans lequel le revêtement comprend au moins l'un des procédés suivants : CVD (dépôt chimique en phase vapeur), PVD (dépôt physique en phase vapeur), PECVD (dépôt chimique en phase vapeur activé au plasma), PICVD (dépôt chimique en phase vapeur à impulsions de plasma), LPCVD (dépôt chimique en phase vapeur à basse pression) ou TCVD (dépôt thermique chimique en phase vapeur).
